(19) Europäisches Patentamt / European Patent Office / Office européen des brevets

(11) **EP 3 249 667 B1**

(12) **EUROPEAN PATENT SPECIFICATION**

(45) Date of publication and mention of the grant of the patent:
**31.10.2018 Bulletin 2018/44**

(51) Int Cl.:
*H01G 7/06* (2006.01)   *H01G 4/18* (2006.01)

(21) Application number: **17180078.2**

(22) Date of filing: **17.08.2015**

(54) **DOPED GRAPHENE ELECTRODES FOR FERROELECTRIC CAPACITOR-BASED MEMORY DEVICE**

DOTIERTE GRAPHENELEKTRODEN FÜR AUF FERROELEKTRISCHEN KONDENSATOREN BASIERTE SPEICHERVORRICHTUNG

ÉLECTRODES EN GRAPHÈNE DOPÉ POUR DISPOSITIF DE MÉMOIRE À CONDENSATEURS FERROÉLECTRIQUES

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **26.08.2014 US 201462041903 P**

(43) Date of publication of application:
**29.11.2017 Bulletin 2017/48**

(62) Document number(s) of the earlier application(s) in accordance with Art. 76 EPC:
**15791732.9 / 3 129 996**

(73) Proprietor: **SABIC Global Technologies B.V.**
**4612 PX Bergen op Zoom (NL)**

(72) Inventor: **KHAN, Mohd, Adnan**
**23955-6900 Thuwal (SA)**

(74) Representative: **J A Kemp**
**14 South Square**
**Gray's Inn**
**London WC1R 5JJ (GB)**

(56) References cited:
**US-A1- 2011 170 330**

- **SUKANG BAE ET AL: "Roll-to-roll production of 30-inch graphene films for transparent electrodes", NATURE NANOTECHNOLOGY, vol. 5, no. 8, 1 August 2010 (2010-08-01), pages 574-578, XP055049935, ISSN: 1748-3387, DOI: 10.1038/nnano.2010.132 & Sukang Bae ET AL: "Supplemantary information Roll-to-roll production of 30-inch graphene films for transparent electrodes", Nature Nanotechnology, vol. 5, no. 8, 20 June 2010 (2010-06-20), pages 574-578, XP055157874, ISSN: 1748-3387, DOI: 10.1038/nnano.2010.132**
- **MAO D ET AL: "Optimization of poly(vinylidene fluoride-trifluoroethylene) films as non-volatile memory for flexible electronics", ORGANIC ELECTRONICS, ELSEVIER, AMSTERDAM, NL, vol. 11, no. 5, 1 May 2010 (2010-05-01), pages 925-932, XP026999947, ISSN: 1566-1199 [retrieved on 2010-02-21]**

Description

## BACKGROUND OF THE INVENTION

### A. Field of the Invention

The present disclosure generally relates to ferroelectric capacitor-based memory devices having low operating voltages, fast switching times, low dielectric loses and low dielectric dispersion for use in nonvolatile memory and energy storage applications. The capacitors include doped graphene bottom and top electrodes or interconnects and a ferroelectric layer having ferroelectric hysteresis properties.

### B. Description of Related Art

Memory systems are used for storage of data, program code, and/or other information in many electronic products, such as personal computer systems, embedded processor-based systems, video image processing circuits, portable phones, and the like. Important characteristics for a memory cell in electronic device are low cost, nonvolatility, high density, writability, low power, and high speed. Conventional memory solutions include Read Only Memory (ROM), Programmable Read only Memory (PROM), Electrically Programmable Memory (EPROM), Electrically Erasable Programmable Read Only Memory (EEPROM), Dynamic Random Access Memory (DRAM) and Static Random Access Memory (SRAM).

ROM is relatively low cost but cannot be rewritten. PROM can be electrically programmed but with only a single write cycle. EPROM has read cycles that are fast relative to ROM and PROM read cycles, but has relatively long erase times and reliability only over a few iterative read/write cycles. EEPROM (or "Flash") is inexpensive, and has low power consumption but has long write cycles (ms) and low relative speed in comparison to DRAM or SRAM. Flash also has a finite number of read/write cycles leading to low long-term reliability. ROM, PROM, EPROM and EEPROM are all non-volatile, meaning that if power to the memory is interrupted the memory will retain the information stored in the memory cells.

DRAM stores charge on transistor gates and must be electrically refreshed every few milliseconds complicating system design by requiring separate circuitry to "refresh" the memory contents before discharge. SRAM does not need to be refreshed and is fast relative to DRAM, but has lower density and is more expensive relative to DRAM. Both SRAM and DRAM are volatile, meaning that if power to the memory is interrupted the memory will lose the information stored in the memory cells.

Consequently, existing technologies are either non-volatile but are not randomly accessible and have low density, high cost, and limited ability to allow multiples writes with high reliability of the circuit's function, or they are volatile and complicate system design or have low density. Some technologies have attempted to over the shortcomings by using graphene in combination with ferroelectric materials in various electronic applications such as amplifiers in acoustic actuators or transistors in solar cells, organic light emitting diodes, touch panels and displays, however, the sheet resistance and transparency are higher than less costly materials (*See,* for example, Bae et al., in ACSNANO, 2013, Vol. 7, pp. 313-3138 and Ni et al., ACSNANO, 2012, Vo. 6, pp. 3935-3942 and U.S. Patent Application Publication No. 2011/0170330).

Other technologies have attempted to address these shortcomings including ferromagnetic RAM (FRAM) which utilize a ferromagnetic region of a ferroelectric capacitor to generate a nonvolatile memory cell. These capacitors are fabricated using two parallel conductive plates separated by a ferroelectric polymer layer. The ferroelectric polymer layer is essentially a thin layer of insulating film which contains a permanent electrical polarization that can be reversed repeatedly, by an opposing electric field. As a result, the ferroelectric capacitor has two possible non-volatile states, which they can retain without electrical power, corresponding to the two binary logic levels in a digital memory. Ferroelectric capacitors typically use a poly(vinylidene fluoride) (PVDF) polymer or PVDF-trifluoroethylene (PVDF-TrFe) copolymer as the ferroelectric material due to its large polarization value and electrical and material properties.

Ferroelectric capacitors also provide energy-storing functionality. When a voltage is applied across the plates, the electric field in the ferroelectric displaces electric charges, and thus stores energy. The amount of energy stored by a ferroelectric capacitor depends on the dielectric constant of the insulating material and the dimensions (total area and thickness) of the film, such that in order to maximize the total amount of energy that a capacitor can accumulate, the dielectric constant and breakdown voltage of the film are maximized, and the thickness of the film minimized.

Current technologies have addressed these problems by fabricating memory cells on flexible substrates, however, these devices suffer from having to be fabricated at low temperatures and require costly materials. Other technologies have fabricated inorganic memory cells with metal interconnects. These devices suffer from being difficult to fabricate on flexible and plastic substrates due to the required high-temperature processing and limited flexibility of the metal contacts. To address the brittleness of the metal interconnects, some technologies manufacture memory cells using thin metal lines such as copper or a transparent conducting oxide such as indium tin oxide (ITO), which are expensive and susceptible to cracking or delaminating under stress as the plastic bends. Still other technologies use thin films of metals, transparent conducting oxides and conducting polymer electrodes to fabricate ferroelectric capacitors. Metals and metal oxide electrodes, however, are brittle and expensive and not ideal for flexible electronics. The conducting polymers currently used in these types of devices suffer from a lower conductivity than ITO.

In, Mao et al. (Organic Electronics 11(5) 2010 925-932), there is described a study on the impact of thermal treatment and thickness on the polarization and leakage current of poly(vinylidene fluoride-trifluoroethylene) [P(VDF-TrFE)] copolymer thin film capacitors. In Sukang et al. (Nature Nanotechnology 5(8) 2010 574-478), there is described the roll-to-roll production and wet-chemical doping of predominantly monolayer 30-inch graphene films grown by chemical vapour deposition onto flexible copper substrates.

## SUMMARY OF THE INVENTION

A solution to the problems associated with the poor performance of ferroelectric capacitors using graphene as the interconnect material has been identified. The solution resides in the discovery and use of doped graphene as the bottom and top electrodes or interconnects in ferroelectric capacitors. Electronic devices made with the ferroelectric capacitor-based memory devices of the present invention have lower operating voltages, faster switching times, lower dielectric loses and have low dielectric dispersion up to high frequencies when compared with capacitors using non-doped graphene as the interconnect material.

The present invention provides the following.

[1] A ferroelectric capacitor-based memory device (100) comprising:

(a) a substrate (104) comprising a flexible polymer substrate;

(b) a bottom electrode (102) comprising a first doped graphene layer deposited on the substrate;

(c) a ferroelectric layer (106) deposited on the first doped graphene layer, wherein the ferroelectric layer has ferroelectric hysteresis properties; and

(d) a top electrode (108) deposited on the ferroelectric layer,

wherein the bottom electrode, the ferroelectric layer, and the top electrode layer are formed on the substrate as a memory cell of the ferroelectric capacitor-based memory device,
characterized in that the top electrode comprises a second doped graphene layer.

[2] The ferroelectric capacitor-based memory device (100) of [1], wherein the sheet resistance of the doped graphene layer is less than 10 kohm/sq,
preferably wherein the sheet resistance of the doped graphene layer is 0.05 to 10 kohm/sq.

[3] The ferroelectric capacitor-based memory device (100) of [1], wherein the flexible polymeric substrate (104) is a polyethylene terephthalate (PET), a polycarbonate (PC) family of polymers, polybutylene terephthalate (PBT), poly(1,4-cyclohexylidene cyclohexane-1,4-dicarboxylate) (PCCD), glycol modified polycyclohexyl terephthalate (PCTG), Poly(phenylene oxide) (PPO), polypropylene (PP), polyethylene (PE), polyvinyl chloride (PVC), polystyrene (PS), polymethylmethacrylate (PMMA), polyethyleneimine (PEI) and its derivatives, thermoplastic elastomer (TPE), terephthalic acid (TPA) elastomers, poly(cyclohexanedimethylene terephthalate) (PCT), polyethylene naphthalate (PEN), polyamide (PA), polystyrene sulfonate (PSS), or polyether ether ketone (PEEK) or combinations or blends thereof,
preferably wherein the flexible polymeric substrate is PET.

[4] The ferroelectric capacitor-based memory device (100) of [1], wherein the doped graphene layer is doped with p-type dopants.

[5] The ferroelectric capacitor-based memory device (100) of [4], wherein:

- the p-type dopants comprise tetrafluoro-tetracyanoquinodimethane (F4-TCNQ), nitrous oxide, bromine, iodide, tetracyanoethylene (TCNE), tetrasodium 1,3,6,8-pyrenetetrasulfonic acid (TPA), diazonium salts, oxygen, self-assembled monolayer of fluoroalkyltrichlorosilane molecules, bismuth, antimony and gold, nitric acid, gold, gold chloride, nitric acid or any combination thereof; or

- the doped graphene layer is doped with gold.

[6] The ferroelectric capacitor-based memory device (100) of [1], wherein the doped graphene layer is doped with n-type dopants.

[7] The ferroelectric capacitor-based memory device (100) of [6], wherein the n-type dopants comprise ethanol, ammonia, potassium, polyethyleneimine, 1, 5-naphthalenediamine, sodium amide, 9, 10-dimethylanthracene, 9, 10-dibromoanthracene, and tetrasodium 1, 3, 6, 8-pyrenetetrasulfonic acid, or any combination thereof.

[8] The ferroelectric capacitor-based memory device (100) of [1], wherein the ferroelectric layer (106) having ferroelectric hysteresis properties comprises a ferroelectric polymer.

[9] The ferroelectric capacitor-based memory device (100) of [8], wherein the ferroelectric polymer is a poly(vinylidene fluoride) (PVDF)-based polymer, polyundecanoamide (Nylon 11)-based polymer, or a blend thereof, preferably a PVDF-based polymer or a blend comprising the PVDF-based polymer.

[10] The ferroelectric capacitor-based memory device (100) of [9], wherein:

- the PVDF-based polymer is blended with a non-PVDF-based polymer, and wherein the non-PVDF polymer is a poly(phenylene oxide) (PPO), a polystyrene (PS), or a poly(methyl methacrylate) (PMMA), or a blend thereof; or

- the PVDF-based polymer is PVDF, PVDF-TrFE, or PVDF-TrFE-CtFE.

[11] The ferroelectric capacitor-based memory device (100) of [1], wherein the ferroelectric layer (106) having ferroelectric hysteresis properties is an inorganic layer comprising ($Pb(Zr_xTi_{1-x})O_3$) or $BaTiO_3$, or a combination thereof.

[12] The ferroelectric capacitor-based memory device (100) of [1], wherein:

- the ferroelectric capacitor exhibits a polarization vs. electric field (P-E) hysteresis loop that is measurable as low as 1 Hz; or

- the ferroelectric capacitor has a total transmittance of incident light of at least 50, 60, 70, 80, or 90%.

[13] A method for producing a ferroelectric capacitor-based memory device (100) of any of [1] to [12], the method comprising:

(a) depositing a first doped graphene layer onto a flexible substrate (104) or depositing a graphene layer onto a flexible substrate (104) followed by doping the graphene layer to produce a first doped graphene layer;

(b) depositing a ferroelectric precursor layer on the first doped graphene layer and annealing the deposited ferroelectric precursor layer to obtain a ferroelectric layer (106) having ferroelectric hysteresis properties; and

(c) depositing a top electrode (108) comprising a second doped graphene layer on the ferroelectric layer having ferroelectric hysteresis properties to obtain the ferroelectric capacitor-based memory device.

[14] The method of [13], wherein:

- the substrate (104) is flexible and the method comprises depositing the graphene layer onto the flexible substrate by a roll-to-roll process; and/or

- the graphene layer is chemical vapor deposition (CVD) graphene or liquid phase exfoliated (LPE) graphene.

[15] A printed circuit board, an integrated circuit, or an electronic device comprising the ferroelectric capacitor-based memory device (100) of any one of [1] to [12].

The graphene can be deposited using chemical vapor deposition (CVD) or liquid phase exfoliate (LPE) techniques and then doped with p-type dopants (electron withdrawing compounds) or n-type dopants (electron donating compounds). P-type dopants include, but are not limited to, the compounds of: tetracyanoquinodimethane (F4-TCNQ), nitrous oxide, bromine, iodide, tetracyanoethylene (TCNE), tetrasodium 1,3,6,8-pyrenetetrasulfonic acid (TPA), diazonium salts, oxygen, self-assembled monolayer of fluoroalkyltrichlorosilane molecules, bismuth, antimony and gold, nitric acid, gold, gold chloride, nitric acid or any combination thereof. In a preferred aspect, the graphene layer is doped with gold. N-type dopants include, but are not limited to, the compounds of: ethanol, ammonia, potassium, polyethyleneimine, 1, 5-naphthalenediamine, sodium amide, 9, 10-dimethylanthracene, 9, 10-dibromoanthracene, and tetrasodium 1, 3, 6, 8-pyrenetetrasulfonic acid, or any combination thereof.

PVDF-based polymers can be a homopolymer, a copolymer, a terpolymer, or a blend thereof. PVDF-based polymers include PVDF, a poly(vinylidene fluoride-tetrafluoroethylene) (PVDF-TrFE), or a poly(vinylidene-fluoride-co-hexafluoropropene) (PVDF-HFP), poly(vinylidene fluoride-co-chlorotrifluoroethylene) (PVDF-CTFE), poly(vinylidene fluoride-co-chlorofluoroethylene) (PVDF-CFE), poly(vinylidene fluoride-co-chlorodifluoroethylene) (PVDF-CDFE), poly(vinylidene fluoride-co-trifluoroethylene-co-chlorofluoroethylene) (PVDF-TrFE-CFE), poly(vinylidene fluoride-co-trifluoroethylene-co-chlorotrifluoroethylene) (PVDF-TrFE-CTFE), poly(vinylidene fluoride-co-trifluoroethylene-co- hexafluoropropylene) (PVDF-TrFE-HFP), poly(vinylidene fluoride-co-trifluoroethylene-co- chlorodifluoroethylene) (PVDF-TrFE-CDFE), poly(vinylidene fluoride-co-tetrafluoroethylene- co-chlorofluoroethylene) (PVDF-TFE-CFE), poly(vinylidene fluoride-co-tetrafluoroethylene- co-chlorotrifluoroethylene) (PVDF-TFE-CTFE), poly(vinylidene fluoride-co- tetrafluoroethylene-co- hexafluoropropylene) (PVDF-TFE-HFP), and poly(vinylidene fluoride- co-tetrafluoroethylene-co- chlorodifluoroethylene) (PVDF-TFE-CD FE), or a polymeric blend thereof. In a particular aspect, the ferroelectric layer having ferroelectric hysteresis properties can have a thickness of 5 nm to 1000 nm.

The top electrode comprises a doped graphene layer. The top electrode or contact can include conductors, such as a metal, a metal oxide or a metal alloy. The metal can be platinum, gold, aluminum, silver or copper. In some aspects, the top electrode that includes a conducting polymer, for example PEDOT:PSS or polyaniline. In other aspects, the top electrode is a metal oxide such as indium-tin-oxide (ITO). In some aspects, the ferroelectric capacitor-based memory device can have a thickness of less than 5000 nm, preferably less than 1000 nm, or more preferably less than 500 nm. The ferroelectric capacitor-based memory device can be transparent. In the method of the present invention, the ferroelectric precursor layer can be deposited onto the first graphene layer by spray coating, ultrasonic spray coating, roll-to-roll coating, ink-jet printing, screen printing, drop casting, spin coating, dip coating, Mayer rod coating, gravure coating, slot die coating, doctor blade coating, extrusion coating, flexography, gravure, offset, rotary screen, flat screen, ink-jet, or laser ablation. The top electrode can be deposited on the ferroelectric layer by spray coating, ultra sonic spray coating, roll-to-roll coating, ink-jet printing, screen printing, drop casting, spin coating, dip coating, Mayer rod coating, gravure coating, slot die coating, doctor blade coating or extrusion coating. In other aspects, the graphene layer can be deposited by other known thin film manufacturing processes.

In another aspect of the invention, the ferroelectric capacitor-based memory device of the present invention can be used in an electronic device, a printed circuit board or an integrated circuit. For example, the ferroelectric capacitor-based memory device of the present invention can be included in at least a portion of a communications circuit, a sensing circuit, or a control circuit of the electronic device, the printed circuit board or the integrated circuit. The circuit can be a piezoelectric sensor, piezoelectric transducer, piezoelectric actuator, a pyroelectric sensor, a pyroelectric sensor, a pyroelectric transducer, or a pyroelectric actuator. Further, electronic devices that include the ferroelectric capacitor-based memory device of the present invention are also contemplated.

The term "ferroelectric material" includes all materials, both organic and inorganic, that exhibit ferroelectric properties, such as retaining a remnant electric field polarization at zero applied electric field.

The phrase "low dielectric constant" when referring to a polymer, includes a polymer having a relative permittivity of 4 or less.

The phrase "polymer blend" includes at least two polymers that have been blended together by any of the known techniques for producing polymer blends. Such techniques include solution blending using a common solvent or melt blend extrusion whereby the components are blended at temperatures above the melting point of the polymers and the obtained mixture is subsequently extruded into granules or directly into sheets or any other suitable form. Screw extruders or mills are commonly used for melt blending polymers. It will also be appreciated the blend of polymers may be a simple powder blend providing that the blend is subjected to a homogenizing process before or during the process of fabricating the ferroelectric material of the present invention. Thus, for example, where a ferroelectric material is formed from at least two polymers in a screw-fed injection-molding machine, the feed to the hopper of the screw may be a simple mixture of the two polymers since a blend may be achieved in the screw portion of the machine.

The term "polymer" includes oligomers (e.g., a polymer having 2 to 10 monomeric units or 2 to 5 monomeric units) and polymers (e.g., a polymer having greater than 10 monomeric units).

The term "electrode" as used in the context of the present invention refers to a conductive material coupled to a component to provide an electrical contact point to the component. For example, in certain embodiments, a capacitor may include two electrodes on opposite sides of an insulator material, such as a ferroelectric layer.

The terms "lower" or "bottom" electrode as used in context of the present invention refers to an electrode positioned on a side of a component closest to the supporting substrate.

The terms "upper" or "top" electrode as used in context of the present invention refers to an electrode positioned on a side of a component farthest from the supporting substrate. Although "bottom electrode" and "top electrode" are defined here and described throughout the disclosure, the terms may be interchangeable, such as when a capacitor is separate from the supporting substrate.

The term "about" or "approximately" are defined as being close to as understood by one of ordinary skill in the art, and in one non-limiting embodiment the terms are defined to be within 10%, preferably within 5%, more preferably within 1%, and most preferably within 0.5%.

The term "substantially" and its variations are defined as being largely but not necessarily wholly what is specified as understood by one of ordinary skill in the art, and in one non-limiting embodiment substantially refers to ranges within 10%, within 5%, within 1%, or within 0.5%.

The terms "inhibiting" or "reducing" or "preventing" or "avoiding" or any variation of these terms, when used in the claims and/or the specification includes any measurable decrease or complete inhibition to achieve a desired result.

The term "effective," as that term is used in the specification and/or claims, means adequate to accomplish a desired, expected, or intended result.

The use of the word "a" or "an" when used in conjunction with the term "comprising" in the claims or the specification may mean "one," but it is also consistent with the meaning of "one or more," "at least one," and "one or more than one."

The words "comprising" (and any form of comprising, such as "comprise" and "comprises"), "having" (and any form of having, such as "have" and "has"), "including" (and any form of including, such as "includes" and "include") or "containing" (and any form of containing, such as "contains" and "contain") are inclusive or open-ended and do not exclude additional, unrecited elements or method steps.

The ferroelectric capacitors of the present invention can "comprise," "consist essentially of," or "consist of' particular ingredients, components, compositions, *etc.* disclosed throughout the specification. With respect to the transitional phase "consisting essentially of," in one non-limiting aspect, a basic and novel characteristic of the ferroelectric capacitors is a bottom electrode comprising a doped graphene layer deposited on a substrate, wherein the sheet resistance of the doped graphene layer is less than 10 kohm/sq and preferably from 1 to 5 kohm/sq.

Other objects, features and advantages of the present invention will become apparent from the following figures, detailed description, and examples. In further aspects, features from specific aspects may be combined with features from other aspects. For example, features from one aspect may be combined with features from any of the other aspects.

## BRIEF DESCRIPTION OF THE DRAWINGS

FIG. 1 is a 2-D cross-sectional view of ferroelectric capacitors.

FIG. 2 is a flow chart of a process to make a ferroelectric capacitor.

FIG. 3 is a schematic of implementation of a circuit in a semiconductor wafer or an electronic device using ferroelectric capacitors.

FIG. 4 is a schematic of implementation of an exemplary wireless communication system in which a ferroelectric capacitor may be advantageously employed.

FIG. 5 is a schematic of an electronic circuit that includes the ferroelectric capacitor.

FIG. 6 is a flowchart of a method for operating an energy storage circuit that includes ferroelectric capacitor.

FIG. 7 is a schematic of a piezoelectric sensor circuit using the ferroelectric capacitor .

FIG. 8 is a 2-D cross-sectional representation of a ferroelectric device with piezoelectric material.

FIG. 9 is a 2-D cross-sectional representation of a ferroelectric device with piezoelectric material.

FIG. 10 are graphs of polarization in $\mu$C/cm$^2$ versus electric field in megavolts per meter (MV/m) of a ferroelectric capacitor having a doped graphene bottom electrode, a comparative ferroelectric capacitor having a platinum electrodes and a comparative ferroelectric capacitor having a graphene bottom electrode.

**FIG. 11** are graphs of switching time measurements dP/d(logt) vs. log (t) plot for a ferroelectric capacitor having a doped graphene bottom electrode, a comparative ferroelectric capacitor having a platinum electrodes and a comparative ferroelectric capacitor having a graphene bottom electrode.

**FIG. 12** are graphs of dielectric permittivity (Constant) versus frequency (Hz) for a ferroelectric capacitor having a doped graphene bottom electrode, a comparative ferroelectric capacitor having a platinum electrodes and a comparative ferroelectric capacitor having an undoped graphene bottom electrode.

**FIG. 13** are graphs of dielectric losses versus frequency (Hz) for a ferroelectric capacitor having a doped graphene bottom electrode, a comparative ferroelectric capacitor having a platinum electrodes and a comparative ferroelectric capacitor having an undoped graphene bottom electrode.

## DETAILED DESCRIPTION OF THE INVENTION

The present discovery overcomes the difficulties associated with current flexible electronic devices. The discovery lies in the use of doped graphene electrodes in a ferroelectric capacitor-based memory device. In particular, a ferroelectric capacitor-based memory device of the present invention includes bottom and top electrodes that can have a doped graphene layer deposited on a flexible substrate. Ferroelectric capacitor-based memory devices made with a doped graphene bottom electrode demonstrate lower operating voltages, faster switching times, lower dielectric loses, and low dielectric dispersion up to high frequencies. In one aspect of the present invention, ferroelectric capacitor-based memory devices using doped graphene electrodes with a sheet resistance of 10 kohm/sq or less, and more preferably a sheet resistance of 0.05 kohm/sq to 10 kohm/sq, have improved performance when compared with the currently available memory-based capacitors.

These and other aspects of the present invention are discussed in further detail in the following sections.

### A. Ferroelectric Capacitor

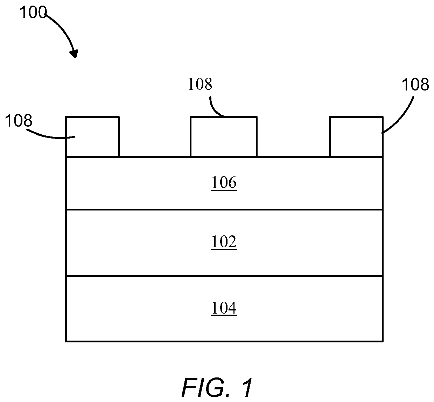

FIG. 1 is a 2-D cross-sectional view of ferroelectric capacitors 100 that include a doped graphene electrode or interconnect 102. The ferroelectric capacitors 100 can include a substrate 104, the doped graphene electrode 102 as the bottom electrode, a ferroelectric material 106, and top electrodes 108. Each of the top electrodes 108 may form a different ferroelectric capacitor that may be independently controlled separate from the other ferroelectric capacitors. Although shown as capacitors sharing the ferroelectric material 106 and the bottom electrode 102, the ferroelectric layer 106 and the bottom electrode 102 may be patterned to form wholly separate capacitor structures. The ferroelectric capacitors 100 can be fabricated on the substrate 104 by forming the ferroelectric material 106 between conducting electrodes 102 and 108. For the purpose of FIG. 1, the ferroelectric material 106 is in the form of a film or layer. Additional materials, layers, and coatings (not shown) known to those of ordinary skill in the art can be used with the ferroelectric capacitors 100, some of which are described below.

The ferroelectric capacitors in FIG. 1 are said to have "memory" because, at zero applied volts, it has two remnant polarization states that do not decay back to zero. These polarization states can be used to represent a stored value, such as binary 0 or 1, and are read by applying a sense voltage between the electrodes 102 and 108 and measuring a current that flows between the electrodes 102 and 108. Also, the amount of charge needed to flip the polarization state to the opposite state can be measured and the previous polarization state is revealed. This means that the read operation changes the polarization state, and can be followed by a corresponding write operation, in order to write back the stored value by again altering the polarization state.

### 1. Substrate

The substrate 104 may be used as a support. The substrate 104 can be made from material that is not easily altered or degraded by heat or organic solvents. Non-limiting examples of such materials include inorganic materials such as silicon, plastic, paper, banknotes substrates, which include polyethylene terephthalate, polycarbonates, and polyetherimide substrates. The substrate is flexible. Other examples of substrates include those that have low glass transition temperatures ($T_g$) (e.g., polyethylene terephthalate (PET), polyethylene (PE), polyvinyl chloride (PVC), polystyrene (PS), or polypropylene (PP)).

## 2. Bottom Electrode or Interconnect

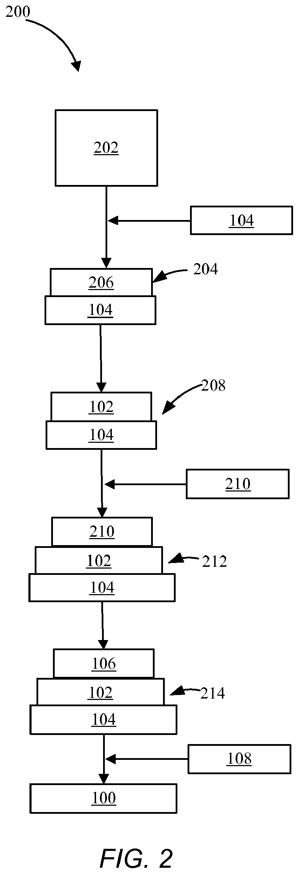

The bottom electrode or interconnect 102 of the present invention is made of a doped graphene layer. Graphene is a two-dimensional monolayer of $sp^2$-bonded hexagonal carbon atoms. The graphene layer can be manufactured using known methods, for example, chemical vapor deposition or liquid phase exfoliation. The graphene layer can be deposed on the substrate 104 using known methods for transferring graphene to substrate materials such as vacuum filtration, polymethylmethacrylate (PMMA), thermal release tapes, or the like. The graphene coated substrate can be doped with a p-type dopant such as nitromethane, nitric acid, gold (Au), gold tetrachloride ($AuCl_3$), sulfuric acid, or thionyl chloride. FIG. 2 is a schematic representing the method 200 for preparing a doped graphene layer electrode of the invention. An electrochemically exfoliated graphene is collected on a material 202 (for example, a copper foil or a nylon material). The substrate 104 (for example, a polyethylene terephthalate film) is placed in contact with the graphene loaded material 202 and subjected to conditions sufficient to transfer or deposit the graphene from the material to the substrate 104 to obtain a stack 204 containing graphene layer 206 deposed on the substrate 104. The graphene layer 206 can be transferred on to the substrate 104 using lamination conditions, roll-to-roll conditions or other known methods for transferring graphene to polymeric substances. The graphene layer 206 can be doped with either a p-type or n-type dopant by contact of the graphene layer 206 with a dopant or dopant solution to form the stack 208 having doped the graphene electrode layer 102 deposed on the substrate 104 (non-limiting examples of p-type and n-type dopants are provided in the Summary of the Invention section of this application. Additional n-type and p-type dopants known to those of skill in the art are also contemplated as being useful in the context of the present invention). For example, the stack 204 can be immersed in a solution of dopant (for example, an alcoholic solution of gold chloride). The sheet resistance of the doped graphene electrode 102 of the stack 208 can be less than 10 kohm/sq, less than 5 kohm/sq, less than 1 kohm/sq, or less than 0.5 kohm/sq. In other embodiments, the stack 208 can be deposited on the surface of other substrates. The sheet resistance can be modified or tuned as desired by increasing the dopant content (to decrease the sheet resistance) or decreasing the dopant content (to increase sheet resistance). By way of example only, immersing the stack 204 in the dopant solution for a longer period of time can serve to increase the dopant level in the graphene layer 206. Conversely, immersing stack 204 for a shorter period of time in the dopant solution can serve to decrease the dopant level in the graphene layer 206.

## 3. Top Electrode or Contact

The top electrode or contact 108 can be disposed on the ferroelectric material 106 by thermal evaporation through a shadow mask. The top electrode comprises a doped graphene layer.

## 4. Ferroelectric Material

Referring back to FIG. 1, the ferroelectric material 106 can be interposed between the lower electrode 102 and the top electrode 108. In one instance, the ferroelectric material 106 can be obtained from a blend of a ferroelectric polymer and a polymer having a low dielectric constant, wherein the polymers have been solubilized in the same solvent or solvent system. In one instance, the ferroelectric material 106 can be obtained from a ferroelectric precursor material, which can include a ferroelectric polymer, copolymer, terpolymer, or a polymer blend that includes a ferroelectric polymer, copolymer, or terpolymer or combinations thereof. Non-limiting examples of ferroelectric polymers include PVDF-based polymers, polyundecanoamide (Nylon 11)-based polymers, or blends of PVDF-based polymers or polyundecanoamide (Nylon 11)-based polymers. The PVDF-based polymer can be a homopolymer, a copolymer, or a terpolymer, or a blend thereof. A non-limiting example of a PVDF-based homopolymer polymer is PVDF. Non-limiting examples of PVDF-based copolymers are poly(vinylidene fluoride-tetrafluoroethylene) (PVDF-TrFE), poly(vinylidene-fluoride-co-hexafluoropropene) (PVDF-HFP), poly(vinylidene-fluoride-chlorotrifluoroethylene) (PVDF-CTFE) or poly(vinylidene-fluoride-chlorofluoroethylene) (PVDF-CFE). Non-limiting examples of PVDF-based terpolymers include poly(vinylidene-fluoride-trifluoroethylene-chlorotrifluoroethylene) (PVDF-TrFE-CTFE) or poly(vinylidene-fluoride-trifluoroethylene-chlorofluoroethylene) (PVDF-TrFE-CFE). The ferroelectric polymer can be blended with a non-ferroelectric polymer. Examples of non-ferroelectric polymers include a poly(phenylene oxide) (PPO), a polystyrene (PS), or a poly(methyl methacrylate) (PMMA), or blends thereof. In preferred aspects, the polymers in the precursor material are solubilized in a solvent or melt such that they do not exhibit ferroelectric hysteresis properties but can be deposited on the doped graphene electrode 102, and then transformed via annealing by, for example heat, to exhibit ferroelectric hysteresis properties. Referring back to FIG. 2, the precursor ferroelectric material 210 can be deposited on the doped graphene electrode 102 via spin-coating, spray coating, ultra sonic spray coating, roll-to-roll coating, ink-jet printing, screen printing, drop casting, dip coating, Mayer rod coating, gravure coating, slot die coating, doctor blade coating, extrusion coating, flexography, gravure, offset, rotary screen, flat screen, ink-jet, or laser ablation. A non-limiting example includes solubilizing a ferroelectric precursor material in a polar solvent to form a thin film. The stack 208 may be placed on a spin coater and the thin film can be applied to the center of the doped graphene electrode layer 102 while spinning at high speed (for example, 2000 rpm) for about 1 minute to spread the ferroelectric precursor material 210 over the doped graphene layer to form stack 212. The stack 212 coated with ferroelectric material precursor 210 can be heated to about 80 °C or more to anneal the precursor and form the stack 214 that contains the substrate 104, the bottom doped graphene electrode layer 102, and the ferroelectric material layer 106. The applied heat converts the precursor material 210 into the ferroelectric material 106, which has ferroelectric hysteresis properties. This annealing step allows for the formulation of a crystalline phase via chemical restricting of the ferroelectric precursor material or removal of the solvent from the ferroelectric precursor material, or both. Subsequently, the stack 214 can be further processed by deposing the top electrode 108 onto at least a surface of the ferroelectric material 106 via a deposition device. The top electrode 108, if needed, can be further cured.

**B. Applications for Ferroelectric Capacitors**

Ferroelectric capacitors can be used in a wide array of technologies and devices including but not limited to: smartcards, RFID cards/tags, piezoelectric sensors, piezoelectric transducers, piezoelectric actuators, pyroelectric sensors, memory devices, non-volatile memory, standalone memory, firmware, microcontrollers, gyroscopes, acoustics sensors, actuators, micro-generators, power supply circuits, circuit coupling and decoupling, radio frequency filtering, delay circuits, radio frequency tuners, passive infra-red sensors ("people detectors"), infrared imaging arrays and fingerprint sensors. If implemented in memory, including firmware, functions may be stored in the ferroelectric capacitors as one or more instructions or code, such that the ferroelectric capacitor-based memory operates as a computer-readable medium. Examples include computer-readable media encoded with a data structure and computer-readable media encoded with a computer program. Computer-readable media includes physical computer storage media. Combinations of the above should also be included within the scope of computer-readable media.

In many of these applications thin films of ferroelectric materials are typically used, as this allows the field required to switch the polarization to be achieved with a moderate voltage, such as less than 5 Volts, preferably less than 3 Volts, and more preferably less than 1.8 Volts. Although some specific circuitry has been set forth, it will be appreciated by those skilled in the art that not all of the disclosed circuitry is required to practice the disclosure. Moreover, certain well known circuits have not been described, to maintain focus on the disclosure.

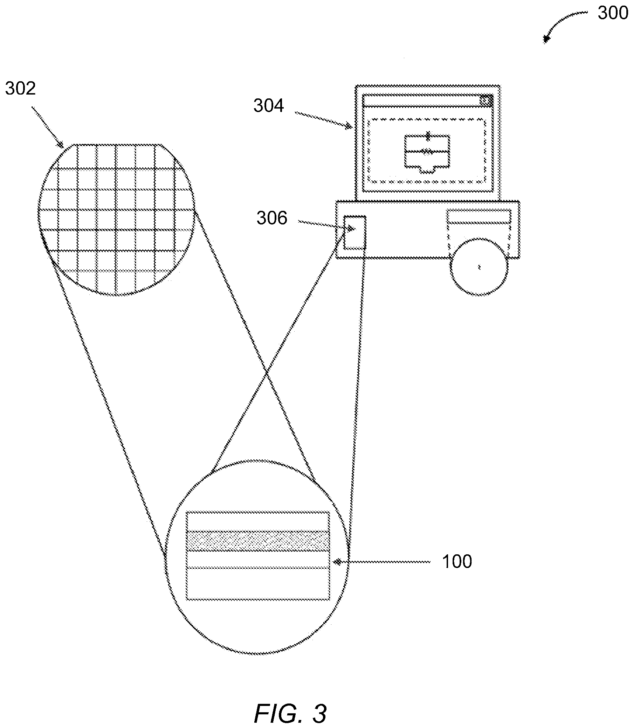

FIG. 3 is block diagram illustrating implementation of an integrated circuit in a semiconductor wafer or an electronic device according to one embodiment. In one case, a ferroelectric capacitor 100 may be manufactured on a wafer 302. The wafer 302 may be singulated into one or more dies that may contain the ferroelectric capacitor 100. Additionally, the wafer 302 may experience further semiconductor manufacturing before singulation. For example, the wafer 302 may be bonded to a carrier wafer, a packaging bulk region, a second wafer, or transferred to another fabrication facility. Alternatively, an electronic device 304 such as, for example, a personal computer, may include a memory device 306 that includes the ferroelectric capacitor 100. Additionally, other parts of the electronic device 304 may include the ferroelectric capacitor 100 such as a central processing unit (CPU), a digital-to-analog converter (DAC), an analog-to-digital converter (ADC), a graphics processing unit (GPU), a microcontroller, or a communications controller.

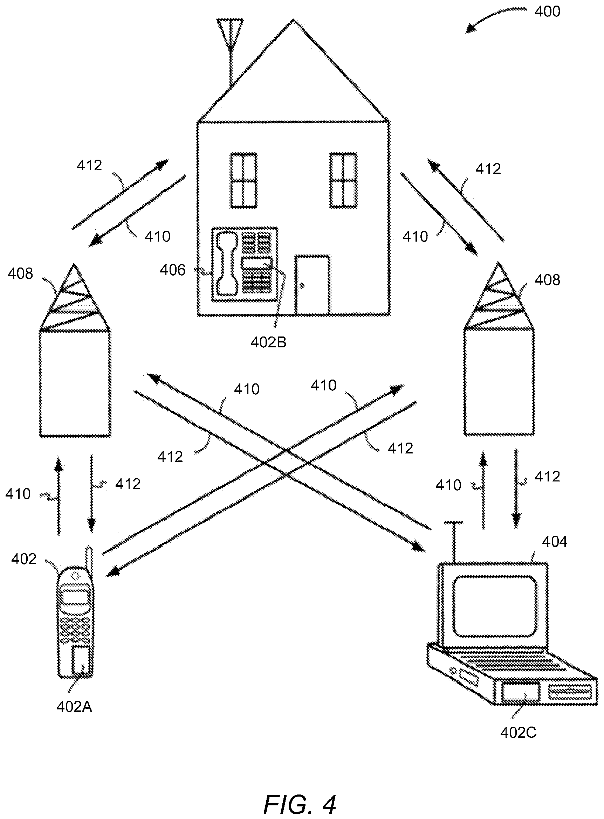

FIG. 4 is a block diagram showing an exemplary wireless communication system 400 in which an embodiment of the disclosure may be advantageously employed. For purposes of illustration, FIG. 4 shows three remote units 402, 404, and 406 and two base stations 408. It will be recognized that wireless communication systems may have many more remote units and base stations. Remote units 402, 404, and 406 include circuit devices 402A, 402C and 402B, which may include integrated circuits or printable circuit boards that include the disclosed ferroelectric capacitor made by the processes of the present invention. It will be recognized that any device containing an integrated circuit or printable circuit board may also include the ferroelectric capacitor disclosed herein, including the base stations, switching devices, and network equipment. FIG. 4 shows forward link signals 410 from the base station 408 to the remote units 402, 404, and 406 and reverse link signals 412 from the remote units 402, 404, and 406 to base stations 408.

In FIG. 4, remote unit 402 is shown as a mobile telephone, remote unit 406 is shown as a portable computer, and remote unit 404 is shown as a fixed location remote unit in a wireless local loop system. For example, the remote units may be mobile phones, handheld personal communication systems (PCS) units, portable data units such as personal data assistants, GPS enabled devices, navigation devices, set upper boxes, music players, video players, entertainment units, fixed location data units such as meter reading equipment, tablets, or any other device that stores or retrieves data or computer instructions, or any combination thereof. Although FIG. 4 illustrates remote units according to the teachings of the disclosure, the disclosure is not limited to these exemplary illustrated units. Embodiments of the disclosure may be suitably employed in any device which includes the ferroelectric capacitor 100 made by the processes disclosed by the present invention.

**C. Use of Ferroelectric Components as Memory Cells**

Ferroelectric components, such as the ferroelectric capacitors described throughout this application, may be operated as memory cells to store data, such as information, code, or instructions. For example, a single ferroelectric capacitor may store a single bit of information, e.g., '1' or '0.' This '1' or '0' value may be stored as a binary polarization direction of the ferroelectric layer in the ferroelectric component. For example, when the ferroelectric layer is polarized from top to bottom, the ferroelectric component stores a '1', and when the ferroelectric layer is polarized from bottom to top, the ferroelectric component stores a '0.' This mapping of polarization states is only one example. Different polarization levels may be used to represent the '1' and '0' data bits in different embodiments of the present invention.

**D. Operation of a Controller for a Ferroelectric Memory Device for Storing Multiple Bits of Information in Memory Cells of the Ferroelectric Memory Device**

A ferroelectric memory device may be constructed with an array of ferroelectric memory capacitors described above, in which each capacitor includes a ferroelectric memory cell. Read and write operations to the ferroelectric memory device may be controlled by a memory controller coupled to the array of multi-level ferroelectric memory cells. One example of a write operation performed by the controller to store information in a single ferroelectric memory cell is described below. A method may include receiving a bit and an address for writing to the addressed ferroelectric memory cell. The bit may be, for example '0' or '1.' Then, a write pulse of a predetermined voltage may be applied across the top and bottom electrodes of the memory cell. The write pulse may create a certain level of remnant polarization in the ferroelectric layer of the ferroelectric memory cell. That remnant polarization affects characteristics of the ferroelectric memory cell, which may be measured at a later time to retrieve the bit that was stored in the ferroelectric memory cell. The cell programming may also include other variations in the write pulse. For example, the controller may generate multiple write pulses to apply to the memory cell to obtain the desired remnant polarization in the ferroelectric layer. In some embodiments, the controller may be configured to follow a write operation with a verify operation. The verify operation may be performed with select write operations, all write operations, or no write operations. The controller may also execute a read operation to obtain the bit stored in the ferroelectric memory cell.

In an array of ferroelectric memory cells, the array may be interconnected by word lines extending across rows of memory cells and bit lines extending across columns of memory cells. The memory controller may operate the word lines and bit lines to select particular memory cells from the array for performing read and/or write operations according to address received from a processor or other component requesting data from the memory array. Appropriate signals may then be applied to the word lines and bit lines to perform the desired read and/or write operation.

**E. Operation as a Decoupling Capacitor and as an Energy Storage Device**

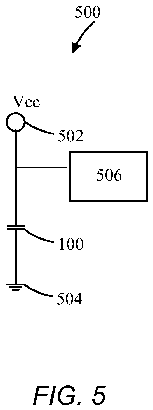

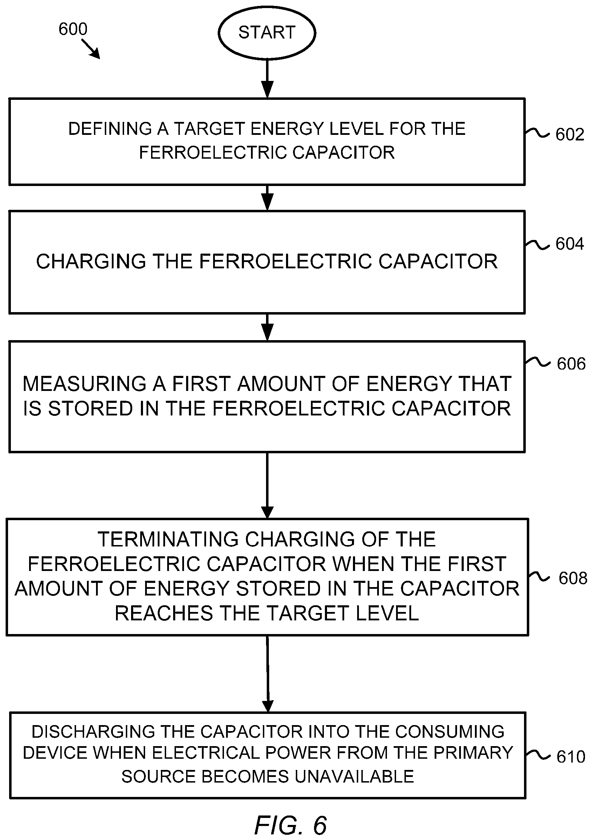

Ferroelectric capacitors can be used to decouple one part of an electrical network (circuit) from another. FIG. 5 is a schematic of circuit 500 that includes the ferroelectric capacitor 100. Ferroelectric capacitor 100 is coupled to power voltage line 502 and a ground voltage line 504. Power noise generated by the power voltage and the ground voltage is shunted through the capacitor, and thus reducing the overall power noise in the circuit 506. The ferroelectric capacitor 100 can provide local energy storage for the device by providing releasing charge to the circuit when the voltage in the line drops. FIG. 6 is a flowchart of a method for operating an energy storage circuit that includes ferroelectric capacitor 100. The ferroelectric capacitor 100 can provide electrical power to a consuming device when electrical power from a primary source is unavailable. Method 600 of FIG. 6 begins at block 602 with defining a target energy level for the ferroelectric capacitor. The target energy level may be, for example, 1 $\mu$F to 20 $\mu$F. After the target energy level is defined, at block 604 the ferroelectric capacitor 100 is charged to the defined energy level. At block 606, a first amount of energy that is stored in the ferroelectric capacitor 100 is measured. When the first amount of energy stored in the ferroelectric capacitor 100 reaches the target energy level, the charging is terminated at block 608. At block 610, when electrical power becomes unavailable from the primary source (for example, a voltage source), the ferroelectric capacitor 100 will discharge energy into the consuming device (for example, a smart phone, computer, or tablet).

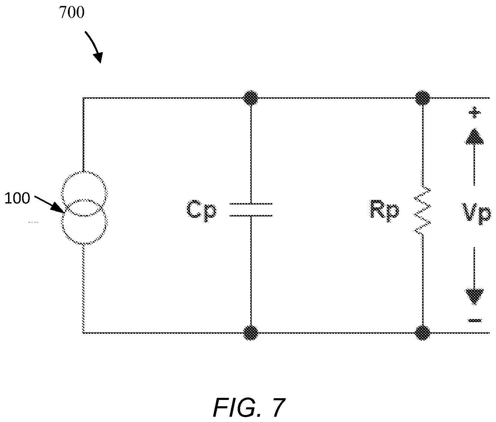

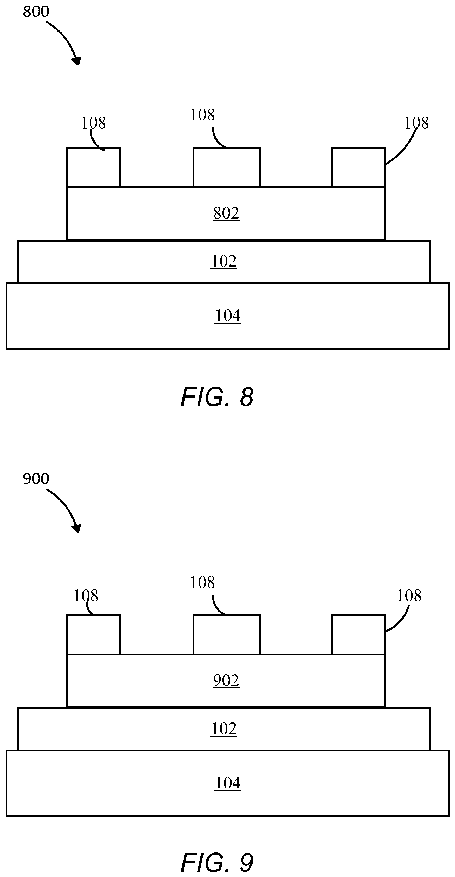

FIG. 7 is a schematic of a piezoelectric sensor circuit using the ferroelectric capacitor 100. When a piezoelectric sensor is at rest, the dipoles formed by the positive and negative ions cancel each other due to the symmetry of the crystal or polymer structure used in the device, and an electric field is not observed. When stressed, the crystal or polymer deforms, symmetry is lost, and a net dipole moment is created. The dipole moment creates an electric field across the crystal. The materials generate an electrical charge that is proportional to the pressure applied. As shown in FIG. 7, the piezoelectric sensor 700 includes the ferroelectric capacitor 100 as a piezoelectric component in the sensor. It is also envisioned that the ferroelectric capacitor 100 can be used as the decoupling capacitor in the same circuit. FIG. 8 is a 2-D cross-sectional representation of a ferroelectric device that includes a piezoelectric material. As shown in FIG. 8, piezoelectric material 802 can be disposed between doped graphene electrode 102 and top electrode 108 in a piezoelectric transducer, and, when stressed create a net dipole moment. The piezoelectric material 802 is, in some aspects, the same as the ferroelectric material described throughout this specification. A method of using a ferroelectric capacitor of the present invention as a piezoelectric capacitor includes sending a vibrational pulse to the piezoelectric capacitor; comparing the capacitor voltage to a reference voltage and adjusting the vibration pulses in response to the comparison. FIG. 9 is a 2-D cross-sectional representation of the ferroelectric device 100 that includes pyroelectric material. As shown in FIG. 9, pyroelectric material 902 can be disposed between doped graphene electrode 102 and top electrode 108 in a pyroelectric device, and then will generate a charge when exposed to infrared light. The pyroelectric material 902 is, in some aspects, the same as the ferroelectric material described throughout this specification. A method of using a ferroelectric capacitor as a pyroelectric capacitor includes sending heat pulse to the pyroelectric capacitor; comparing the capacitor voltage to a reference voltage; and adjusting the heat pulses in response to the comparison.

## EXAMPLES

The present invention will be described in greater detail by way of specific examples. The following examples are offered for illustrative purposes.

**Reference Example 1**

**(Fabrication of Ferroelectric Capacitors with a first Doped Graphene Electrodes)**

A ferroelectric capacitor was fabricated using a doped graphene as the bottom electrode using the following method.

**Doped graphene electrode.** High performance PET substrates were cleaned with acetone, ethanol and deionized water prior to device fabrication. Liquid phase exfoliated (LPE) graphene bottom electrodes were made by vacuum filtration of the electrochemically exfoliated graphene solution on a nylon filter of 0.2 $\mu$m of pore diameter to form a graphene film. The graphene film was transferred onto polyethylene terephthalate (PET, SABIC) by a roll-to roll method. The sheet resistance was calculated by a four probe measurement unit. Gold tetrachloride ($AuCl_3$, 10 mM) was dispersed in ethanol and the graphene coated PET was immersed in the $AuCl_3$-ethanol solution for thirty (30) seconds. The procedure was repeated for samples 2 and 3. The sheet resistance values of three doped graphene electrodes are listed in Table 1.

**Table 1**

| Sample # | Sheet Resistance after doping (kohm/sq) | Transmittance (%) |
|----------|------------------------------------------|--------------------|
| 1 | 0.9 | 57 |
| 2 | 8 | 60 |

**Ferroelectric material and top electrode.** A 3 wt.% solution of ferroelectric PVDF-TrFE was prepared in methyl-ethyl-ketone (MEK) solvent. The ferroelectric thin film was spun on the doped graphene electrode at 2000 rpm for 60 seconds to form a ferroelectric layer of about 400 nm thickness. The film was annealed on a hotplate for 30 minutes at 80 °C prior to annealing in a vacuum furnace at 130 °C for 2 hours to improve the crystallinity. A 100 nm thick top Au electrode was deposited by thermal evaporation through a shadow mask.

**Comparative Example 2**

**(Fabrication of a Comparative Ferroelectric Capacitor with an Undoped Graphene Bottom Electrode)**

Comparative ferroelectric capacitors were fabricated on flexible substrates with undoped graphene as the bottom electrode.

**Graphene electrode.** High performance PET substrates were cleaned with acetone, ethanol and deionized water prior to device fabrication. The liquid phase exfoliated (LPE) graphene bottom electrodes were made by vacuum filtration of the electrochemically exfoliated graphene solution on a nylon filter of 0.2 $\mu$m of pore diameter to form a graphene film. The graphene film was transferred onto polyethylene terephthalate (PET, SABIC) by a roll-to roll method. The sheet resistance values of the comparative graphene electrodes are listed in Table 2.

**Table 2**

| Sample # | Sheet Resistance kohm/sq) | Transmittance (%) |
|---|---|---|
| C1 | 12 | 57 |
| C2 | 20 | 60 |

**Ferroelectric material and top electrode.** A 3 wt.% solution of ferroelectric PVDF-TrFE was prepared in methyl-ethyl-ketone (MEK) solvent. The ferroelectric thin film was spun on the graphene electrode at 2000 rpm for 60 seconds to form a ferroelectric layer of about 400 nm thickness. The film was annealed on a hotplate for 30 minutes at 80 °C prior to annealing in a vacuum furnace at 130 °C for 2 hours to improve the crystallinity. A 100 nm thick top Au electrode was deposited by thermal evaporation through a shadow mask.

**Reference Example 3**

**(Operation of the Devices)**

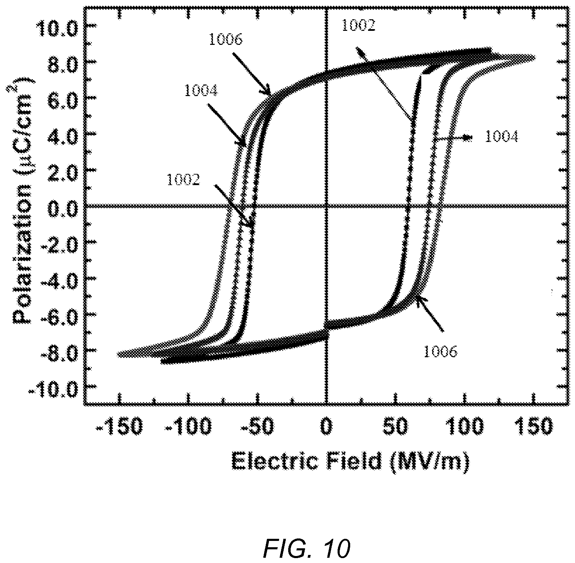

**Hysteresis Measurements.** Hysteresis loops for the ferroelectric capacitors made in Reference Example 1 (Sample number 1), the comparative graphene ferroelectric capacitors made in Comparative Example 2 (sample number, C1) and a comparative ferroelectric capacitor with a platinum bottom electrode (Pt device) and having a 400 nm thick ferroelectric layer were measured at a frequency of 10 Hz and are depicted in FIG. 10. FIG. 10 is a graphical depiction of the polarization ($\mu$C/cm$^2$) versus electric field (MV/m) at 10 Hz for a ferroelectric capacitor, a comparative ferroelectric capacitor having a platinum electrodes and a comparative ferroelectric capacitor having a graphene bottom electrode. Data 1002 was the comparative platinum capacitor, data 1004 was the doped graphene capacitor and data 1006 was the comparative undoped graphene capacitor. As shown in FIG. 10 well-saturated loops with saturation polarization ($P_s$) of 8.6 $\mu$C/cm$^2$ and remnant polarization ($P_r$) of ~ 7.2 $\mu$C/cm$^2$ were produced, which indicated good crystallinity of the PVDF-TrFE film irrespective of the electrodes used. To achieve the same polarization as the Pt device, higher saturation fields were applied to the capacitors with graphene electrodes. A consistent increase in the positive and negative switching fields was observed for the graphene capacitors as compared to the Pt capacitor. Without wising to be bound by theory, it is believed that the increase in coercive fields ($+E_c/-E_c$) from [+58/-53] MV/m for the Pt capacitor and to [+82/-70 MV/m] for the comparative graphene capacitor can be attributed to the poor conductivity of the undoped (comparative) graphene, which led to a large voltage drop across the un-patterned bottom electrode. The poorly conducting graphene electrode acted as a large resistor connected in series with the ferroelectric capacitor and the intrinsic coercive field of the ferroelectric film itself did not change. Instead, a higher voltage was needed to reach the required coercive field to switch the dipoles in the ferroelectric copolymer film. In contrast to the comparative graphene capacitor, the doped graphene capacitor displayed coercive fields closer to the Pt capacitor (+72 MV/m / -61 MV/m). This difference was a substantial improvement in coercive fields compared to the comparative graphene capacitor.

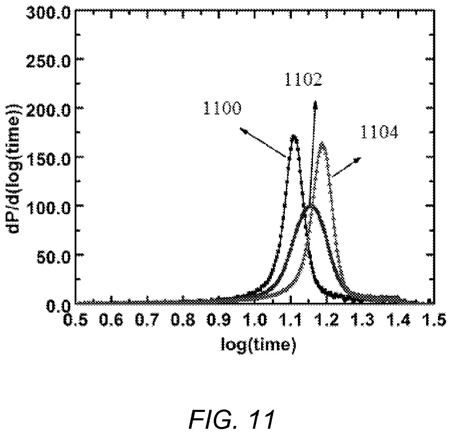

**Switching Characteristics.** Switching characteristics of the capacitors are shown in FIG. 11. Switching characteristics were obtained by a time domain measurement of the charge density or polarization (P) response. Switching times ($t_s$) were estimated from the time of the maximum of dP/d(logt) vs. log (t) plot. FIG. 11 are graphical depictions of time measurements dP/d(logt) vs. log (t) plot for the ferroelectric capacitor having a doped graphene bottom electrode (Sample 1 in Reference Example 1), the comparative ferroelectric capacitor having a platinum electrodes and the comparative ferroelectric capacitor having a graphene bottom electrode (Sample C1). Data 1100 is the Pt capacitor, data 1102 is the doped graphene capacitor, and data 1104 is the comparative graphene capacitor. At applied fields of 140 MV/m, the comparative Pt capacitor exhibited a switching time of 12.88 ms while the comparative graphene capacitor and the doped graphene capacitor exhibited switching times of 15.45 ms and 13.8 ms respectively. Without wishing to be bound by theory, it is believed that the switching time, $t_s$, is dependent on the applied electric field. Switching time can be represented by Equation (1):

$$t_s = t_{s\infty}\, e^{(E_a/E)} \quad (1)$$

where $t_{s\infty}$ is the limited switching time, $E_a$ is the activation field, and E is applied electric field.

Applying Equation I, the switching time increases for lower applied fields in the ferroelectric capacitors. For the comparative graphene capacitor, the voltage drop across the bottom electrode had lower applied fields across the ferroelectric film, which led to a higher switching time relative to the Pt capacitor. The doped graphene ferroelectric capacitor had a switching time of 13.8 ms, which approached the switching time of the Pt device. Thus, the doped graphene ferroelectric capacitor demonstrates enhanced switching time as compared to the comparative graphene capacitors.

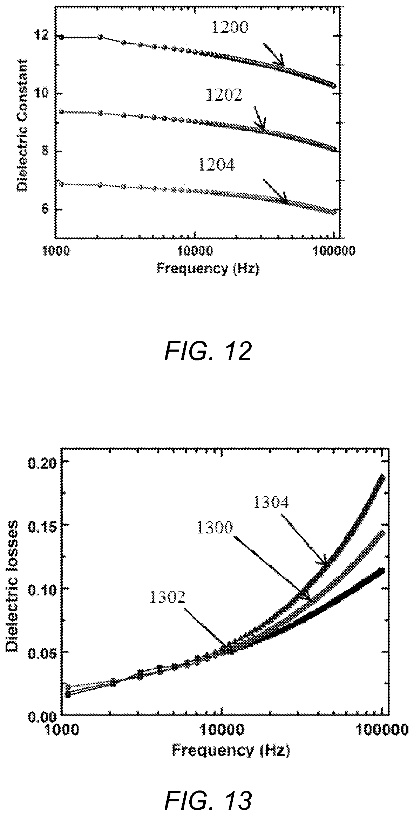

**Dielectric Permittivity/Dielectric Constant Measurements.** FIG. 12 are graphical representations of relative dielectric permittivity (constant) versus frequency (Hz) of the ferroelectric capacitor having a doped graphene bottom electrode (Sample 1 of Reference Example 1), the comparative ferroelectric capacitor having a platinum electrode and the comparative ferroelectric capacitor having a graphene bottom electrode (Sample C1). Data 1200 is for the Pt capacitor, data 1202 is for the ferroelectric capacitor having a doped graphene bottom electrode, and data 1204 is for comparative capacitor with an undoped graphene electrode. FIG. 13 are graphical representations of dielectric losses versus frequency (Hz) for the doped graphene ferroelectric capacitor, the comparative ferroelectric capacitor having a platinum electrodes, and the comparative ferroelectric capacitor having a graphene bottom electrode. Data 1300 is the Pt capacitor, data 1302 is the doped graphene capacitor, and data 1304 is the comparative graphene capacitor. As shown, the permittivity of the comparative graphene capacitor was less than the permittivity of the doped graphene ferroelectric capacitor. The dielectric response of ferroelectric capacitors were represented with an equivalent circuit consisting of a resistor in series with a parallel RC circuit. Ferroelectric capacitors with poorly conducting electrodes demonstrated lower permittivity and higher dielectric losses as compared to a Pt capacitor, which is depicted in FIGS. 12 and 13, respectively. The dielectric loss, for the comparative undoped graphene capacitor (0.19 at 100 KHz) was higher than the dielectric loss for the doped graphene capacitor (0.14 at 100 KHz) and the Pt capacitor for the comparative Pt capacitor (~0.11 at 100 KHz). Thus, the doped graphene ferroelectric capacitor demonstrated improved dielectric permittivity and dielectric constant measurements as compared to the comparative graphene capacitor.

As shown in the data, doped graphene ferroelectric capacitors have similar electrical properties as ferroelectric capacitors with Pt bottom electrodes and better electrical properties as compared to the comparative ferroelectric capacitors having an undoped graphene bottom electrode. Thus, doped graphene ferroelectric capacitors have improved durability, operating voltage, switching time, dielectric loss, low dielectric dispersion, which beneficial for use in flexible electronic devices.

**Claims**

1. A ferroelectric capacitor-based memory device (100) comprising:

    (a) a substrate (104) comprising a flexible polymer substrate;
    (b) a bottom electrode (102) comprising a first doped graphene layer deposited on the substrate;
    (c) a ferroelectric layer (106) deposited on the first doped graphene layer, wherein the ferroelectric layer has ferroelectric hysteresis properties; and
    (d) a top electrode (108) deposited on the ferroelectric layer,

    wherein the bottom electrode, the ferroelectric layer, and the top electrode layer are formed on the substrate as a memory cell of the ferroelectric capacitor-based memory device,
    **characterized in that** the top electrode comprises a second doped graphene layer.

2. The ferroelectric capacitor-based memory device (100) of claim 1, wherein the sheet resistance of the doped graphene layer is less than 10 kohm/sq,
   preferably wherein the sheet resistance of the doped graphene layer is 0.05 to 10 kohm/sq.

3. The ferroelectric capacitor-based memory device (100) of claim 1, wherein the flexible polymeric substrate (104) is a polyethylene terephthalate (PET), a polycarbonate (PC) family of polymers, polybutylene terephthalate (PBT), poly(1,4-cyclohexylidene cyclohexane-1,4-dicarboxylate) (PCCD), glycol modified polycyclohexyl terephthalate (PCTG), Poly(phenylene oxide) (PPO), polypropylene (PP), polyethylene (PE), polyvinyl chloride (PVC), polystyrene (PS), polymethylmethacrylate (PMMA), polyethyleneimine (PEI) and its derivatives, thermoplastic elastomer (TPE), terephthalic acid (TPA) elastomers, poly(cyclohexanedimethylene terephthalate) (PCT), polyethylene naphthalate (PEN), polyamide (PA), polystyrene sulfonate (PSS), or polyether ether ketone (PEEK) or combinations or blends thereof,
   preferably wherein the flexible polymeric substrate is PET.

4. The ferroelectric capacitor-based memory device (100) of claim 1, wherein the doped graphene layer is doped with p-type dopants.

5. The ferroelectric capacitor-based memory device (100) of claim 4, wherein:

    - the p-type dopants comprise tetrafluoro-tetracyanoquinodimethane (F4-TCNQ), nitrous oxide, bromine, iodide, tetracyanoethylene (TCNE), tetrasodium 1,3,6,8-pyrenetetrasulfonic acid (TPA), diazonium salts, oxygen, self-assembled monolayer of fluoroalkyltrichlorosilane molecules, bismuth, antimony and gold, nitric acid, gold, gold chloride, nitric acid or any combination thereof; or
- the doped graphene layer is doped with gold.

6. The ferroelectric capacitor-based memory device (100) of claim 1, wherein the doped graphene layer is doped with n-type dopants.

7. The ferroelectric capacitor-based memory device (100) of claim 6, wherein the n-type dopants comprise ethanol, ammonia, potassium, polyethyleneimine, 1, 5-naphthalenediamine, sodium amide, 9, 10-dimethylanthracene, 9, 10-dibromoanthracene, and tetrasodium 1, 3, 6, 8-pyrenetetrasulfonic acid, or any combination thereof.

8. The ferroelectric capacitor-based memory device (100) of claim 1, wherein the ferroelectric layer (106) having ferroelectric hysteresis properties comprises a ferroelectric polymer.

9. The ferroelectric capacitor-based memory device (100) of claim 8, wherein the ferroelectric polymer is a poly(vinylidene fluoride) (PVDF)-based polymer, polyundecanoamide (Nylon 11)-based polymer, or a blend thereof, preferably a PVDF-based polymer or a blend comprising the PVDF-based polymer.

10. The ferroelectric capacitor-based memory device (100) of claim 9, wherein:

    - the PVDF-based polymer is blended with a non-PVDF-based polymer, and wherein the non-PVDF polymer is a poly(phenylene oxide) (PPO), a polystyrene (PS), or a poly(methyl methacrylate) (PMMA), or a blend thereof; or
    - the PVDF-based polymer is PVDF, PVDF-TrFE, or PVDF-TrFE-CtFE.

11. The ferroelectric capacitor-based memory device (100) of claim 1, wherein the ferroelectric layer (106) having ferroelectric hysteresis properties is an inorganic layer comprising $(Pb(Zr_xTi_{1-x})O_3)$ or $BaTiO_3$, or a combination thereof.

12. The ferroelectric capacitor-based memory device (100) of claim 1, wherein:

    - the ferroelectric capacitor exhibits a polarization vs. electric field (P-E) hysteresis loop that is measurable as low as 1 Hz; or
    - the ferroelectric capacitor has a total transmittance of incident light of at least 50, 60, 70, 80, or 90%.

13. A method for producing a ferroelectric capacitor-based memory device (100) of any of claims 1 to 12, the method comprising:

    (a) depositing a first doped graphene layer onto a flexible substrate (104) or depositing a graphene layer onto a flexible substrate (104) followed by doping the graphene layer to produce a first doped graphene layer;
    (b) depositing a ferroelectric precursor layer on the first doped graphene layer and annealing the deposited ferroelectric precursor layer to obtain a ferroelectric layer (106) having ferroelectric hysteresis properties; and
    (c) depositing a top electrode (108) comprising a second doped graphene layer on the ferroelectric layer having ferroelectric hysteresis properties to obtain the ferroelectric capacitor-based memory device.

14. The method of claim 13, wherein:

    - the substrate (104) is flexible and the method comprises depositing the graphene layer onto the flexible substrate by a roll-to-roll process; and/or
    - the graphene layer is chemical vapor deposition (CVD) graphene or liquid phase exfoliated (LPE) graphene.

15. A printed circuit board, an integrated circuit, or an electronic device comprising the ferroelectric capacitor-based memory device (100) of any one of claims 1 to 12.

EP 3 249 667 B1

**Patentansprüche**

1. Ferroelektrische Kondensator-basierte Speichervorrichtung (100), umfassend:

(a) ein Substrat (104), umfassend ein flexibles polymeres Substrat;
(b) eine Bodenelektrode (102), umfassend eine erste dotierte Graphenschicht, angeordnet auf dem Substrat;
(c) eine ferroelektrische Schicht (106), angeordnet auf der ersten dotierten Graphenschicht, wobei die ferroelektrische Schicht ferroelektrische Hystereseeigenschaften hat; und
(d) eine obere Elektrode (108), angeordnet auf der ferroelektrischen Schicht,

wobei die Bodenelektrode, die ferroelektrische Schicht und die obere Elektrodenschicht als eine Speicherzelle der ferroelektrischen Kondensator-basierten Speichervorrichtung auf dem Substrat gebildet sind, **dadurch gekennzeichnet, dass** die obere Elektrode eine zweite Graphenschicht umfasst.

2. Ferroelektrische Kondensator-basierte Speichervorrichtung (100) nach Anspruch 1, wobei der Schichtwiderstand der dotierten Graphenschicht weniger als 10 kohm/sq beträgt, wobei vorzugsweise der Schichtwiderstand der dotierten Graphenschicht 0,05 bis 10 kohm/sq beträgt.

3. Ferroelektrische Kondensator-basierte Speichervorrichtung (100) nach Anspruch 1, wobei das flexible polymere Substrat (104) Folgendes ist: ein Polyethylenterephthalat (PET), eine Polycarbonat(PC)familie von Polymeren, Polybutylenterephthalat (PBT), Poly(1,4-cyclohexylidencyclohexan-1,4-dicarboxylat) (PCCD), Glycol-modifiziertes Polycyclohexylterephthalat (PCTG), Poly(phenylenoxid) (PPO), Polypropylen (PP), Polyethylen (PE), Polyvinylchlorid (PVC), Polystyren (PS), Polymethylmethacrylat (PMMA), Polyethylenimin (PEI) und seine Derivate, thermoplastisches Elastomer (TPE), Terephthalsäure (TPA)- Elastomere, Poly(cyclohexandimethylenterephthalat) (PCT), Polyethylennaphthalat (PEN), Polyamid (PA), Polystyrolsulfonat (PSS) oder Polyetheretherketon (PEEK) oder Kombinationen oder Mischungen davon, wobei vorzugsweise das flexible polymere Substrat PET ist.

4. Ferroelektrische Kondensator-basierte Speichervorrichtung (100) nach Anspruch 1, wobei die dotierte Graphenschicht mit p-artigen Dotierstoffen dotiert ist.

5. Ferroelektrische Kondensator-basierte Speichervorrichtung (100) nach Anspruch 4, wobei:

- die p-artigen Dotierstoffe Folgendes umfassen:
Tetrafluortetracyanoquinodimethan (F4-TCNQ), Distickstoffoxid, Brom, Iodid, Tetracyanoethylen (TCNE), Tetranatrium- 1,3,6,8-pyrentetrasulfonsäure (TPA), Diazoniumsalze, Sauerstoff, selbstorganisierende Monoschicht von Fluoralkyltrichlorsilanmolekülen, Wismut, Antimon und Gold, Salpetersäure, Gold, Goldchlorid, Salpetersäure oder eine beliebige Kombination davon; oder
- die dotierte Graphenschicht mit Gold dotiert ist.

6. Ferroelektrische Kondensator-basierte Speichervorrichtung (100) nach Anspruch 1, wobei die dotierte Graphenschicht mit n-artigen Dotierstoffen dotiert ist.

7. Ferroelektrische Kondensator-basierte Speichervorrichtung (100) nach Anspruch 6, wobei die n-artigen Dotierstoffe Folgendes umfassen: Ethanol, Ammoniak, Kalium, Polyethylenimin, 1, 5-Naphthalendiamin, Natriumamid, 9, 10-Dimethylanthracen, 9, 10-Dibromanthracen und Tetranatrium-1, 3, 6, 8-Pyrentetrasulfonsäure oder eine beliebige Kombination davon.

8. Ferroelektrische Kondensator-basierte Speichervorrichtung (100) nach Anspruch 1, wobei die ferroelektrische Schicht (106) mit ferroelektrischen Hystereseeigenschaften ein ferroelektrisches Polymer umfasst.

9. Ferroelektrische Kondensator-basierte Speichervorrichtung (100) nach Anspruch 8, wobei das ferroelektrische Polymer Folgendes ist: ein Poly(vinylidenfluorid) (PVDF)-basiertes Polymer, Polyundecanoamid (Nylon 1 1)-basiertes Polymer oder eine Mischung davon, vorzugsweise ein PVDF-basiertes Polymer oder eine Mischung, die das PVDF-basierte Polymer umfasst.

10. Ferroelektrische Kondensator-basierte Speichervorrichtung (100) nach Anspruch 9, wobei:

15

- das PVDF-basierte Polymer mit einem nicht-PVDF-basierten Polymer gemischt ist und wobei das nicht-PVDF Polymer Folgendes ist: ein Poly(phenylenoxid) (PPO), ein Polystyren (PS) oder ein Poly(methylmethacrylat) (PMMA) oder eine Mischung davon; oder
- das PVDF-basierte Polymer Folgendes ist: PVDF, PVDF-TrFE oder PVDF-TrFE-CtFE.

**11.** Ferroelektrische Kondensator-basierte Speichervorrichtung (100) nach Anspruch 1, wobei die ferroelektrische Schicht (106) mit ferroelektrischen Hystereseeigenschaften eine anorganische Schicht ist, umfassend $(Pb(Zr_xTi_{1-x})O_3)$ oder $BaTiO_3$ oder eine Kombination davon.

**12.** Ferroelektrische Kondensator-basierte Speichervorrichtung (100) nach Anspruch 1, wobei:

- der ferroelektrische Kondensator eine Polarisierung vs. Elektrisches Feld (P-E) - Hystereseschleife zeigt, die bis zu 1 Hz messbar ist; oder
- der ferroelektrische Kondensator eine Gesamtdurchlässigkeit von einfallendem Licht von mindestens 50, 60, 70, 80 oder 90 % aufweist.

**13.** Verfahren zur Herstellung einer ferroelektrischen Kondensator-basierten Speichervorrichtung (100) nach einem der Ansprüche 1 bis 12, das Verfahren umfassend:

(a) Anordnen einer ersten dotierten Graphenschicht auf ein flexibles Substrat (104) oder Anordnen einer Graphenschicht auf ein flexibles Substrat (104) gefolgt von einer Dotierung der Graphenschicht, um eine erste dotierte Graphenschicht zu produzieren;
(b) Anordnen einer ferroelektrischen Vorläuferschicht auf der ersten dotierten Graphenschicht und Härten der angeordneten ferroelektrischen Vorläuferschicht, um eine ferroelektrische Schicht (106) mit ferroelektrischen Hystereseeigenschaften zu erhalten; und
(c) Anordnen einer oberen Elektrode (108), umfassend eine zweite dotierte Graphenschicht, auf der ferroelektrischen Schicht mit ferroelektrischen Hystereseeigenschaften, um die ferroelektrische Kondensator-basierte Speichervorrichtung zu erhalten.

**14.** Verfahren nach Anspruch 13, wobei:

- das Substrat (104) flexibel ist und das Verfahren das Anordnen der Graphenschicht durch ein Rollenverfahren auf das flexible Substrat umfasst; und/oder
- die Graphenschicht chemisches Dampfabscheidungs (CVD) - Graphen oder Flüssigphasen-exfoliertes (LPE) Graphen ist

**15.** Gedruckte Schaltungsplatte, integrierte Schaltung oder elektronische Vorrichtung, umfassend die ferroelektrische Kondensator-basierte Speichervorrichtung (100) nach einem der Ansprüche 1 bis 12.

**Revendications**

**1.** Dispositif de mémoire à base de condensateur ferroélectrique (100), comprenant :

(a) un substrat (104) comprenant un substrat en polymère flexible ;
(b) une électrode inférieure (102) comprenant une première couche de graphène dopée déposée sur le substrat ;
(c) une couche ferroélectrique (106) déposée sur la première couche de graphène dopée, la couche ferroélectrique ayant des propriétés d'hystérésis ferroélectrique ; et
(d) une électrode supérieure (108) déposée sur la couche ferroélectrique,

l'électrode inférieure, la couche ferroélectrique et l'électrode supérieure étant formées sur le substrat sous la forme d'une cellule de mémoire du dispositif de mémoire à base de condensateur ferroélectrique, **caractérisé en ce que** l'électrode supérieure comprend une deuxième couche de graphène dopée.

**2.** Dispositif de mémoire à base de condensateur ferroélectrique (100) de la revendication 1, dans lequel la résistance en feuille de la couche de graphène dopée est inférieure à 10 kohm/carré, de préférence la résistance en feuille de la couche de graphène dopée étant de 0,05 à 10 kohm/carré.

EP 3 249 667 B1

**3.** Dispositif de mémoire à base de condensateur ferroélectrique (100) de la revendication 1, dans lequel le substrat polymère flexible (104) est un polytéréphtalate d'éthylène (PET), une famille polycarbonate (PC) de polymères, le polytéréphtalate de butylène (PBT), le poly(cyclohexane-1,4-dicarboxylate de 1,4-cyclohexylidène) (PCCD), le polycyclohexyl téréphtalate modifié par glycol (PCTG), le poly(oxyde de phénylène) (PPO), le polypropylène (PP), le polyéthylène (PE), le polychlorure de vinyle (PVC), le polystyrène (PS), le polyméthacrylate de méthyle (PMMA), la polyéthylèneimine (PEI) et ses dérivés, un élastomère thermoplastique (TPE), des élastomère à base d'acide téréphtalique (TPA), le poly(téréphtalate de cyclohexanediméthylène) (PCT), le polynaphtalate d'éthylène (PEN), un polyamide (PA), le polysulfonate de styrène (PSS) ou la polyéther éther cétone (PEEK) ou des combinaisons ou mélanges de ceux-ci,

de préférence le substrat polymère flexible étant en PET.

**4.** Dispositif de mémoire à base de condensateur ferroélectrique (100) de la revendication 1, dans lequel la couche de graphène dopée est dopée avec des dopants de type p.

**5.** Dispositif de mémoire à base de condensateur ferroélectrique (100) selon la revendication 4, dans lequel :
les dopants de type p comprennent le tétrafluoro-tétracyanoquinodiméthane (F4-TCNQ), l'oxyde nitreux, le brome, un iodure, le tétracyanoéthylène (TCNE), l'acide 1,3,6,8-pyrènetétrasulfonique tétrasodique (TPA), des sels de diazonium, l'oxygène, une monocouche auto-assemblée de molécules de fluoroalkyltrichlorosilane, le bismuth, l'antimoine et l'or, l'acide nitrique, l'or, le chlorure d'or, l'acide nitrique ou une combinaison quelconque de ceux-ci ; ou

- la couche de graphène dopée est dopée avec de l'or.

**6.** Dispositif de mémoire à base de condensateur ferroélectrique (100) de la revendication 1, dans lequel la couche de graphène dopée est dopée avec des dopants de type n.

**7.** Dispositif de mémoire à base de condensateur ferroélectrique (100) de la revendication 6, dans lequel les dopants de type n comprennent l'éthanol, l'ammoniaque, le potassium, la polyéthylèneimine, la 1,5-naphthalènediamine, l'amidure de sodium, le 9,10-diméthylanthracène, le 9,10-dibromoanthracène et l'acide 1,3,6,8-pyrènetétrasulfonique tétrasodique, ou une combinaison quelconque de ceux-ci.

**8.** Dispositif de mémoire à base de condensateur ferroélectrique (100) de la revendication 1, dans lequel la couche ferroélectrique (106) ayant des propriétés d'hystérésis ferroélectrique comprend un polymère ferroélectrique.

**9.** Dispositif de mémoire à base de condensateur ferroélectrique (100) de la revendication 8, dans lequel le polymère ferroélectrique est un polymère à base de poly(fluorure de vinylidène) (PVDF), un polymère à base de polyundécanoamide (Nylon 11) ou un mélange de ceux-ci, de préférence un polymère à base de PVDF ou un mélange comprenant le polymère à base de PVDF.

**10.** Dispositif de mémoire à base de condensateur ferroélectrique (100) selon la revendication 9, dans lequel :

- le polymère à base de PVDF est mélangé avec un polymère sans PVDF, et dans lequel le polymère sans PVDF est un poly(oxyde de phénylène) (PPO), un polystyrène (PS) ou un poly(méthacrylate de méthyle) (PMMA) ou un mélange de ceux-ci ; ou
- le polymère à base de PVDF est le PVDF, le PVDF-TrFE ou le PVDF-TrFE-CtFE.

**11.** Dispositif de mémoire à base de condensateur ferroélectrique (100) de la revendication 1, dans lequel la couche ferroélectrique (106) ayant des propriétés d'hystérésis ferroélectrique est une couche inorganique comprenant (Pb(Zr$_x$Ti$_{1-x}$)O$_3$) ou BaTiO$_3$ ou une combinaison de ceux-ci.

**12.** Dispositif de mémoire à base de condensateur ferroélectrique (100) selon la revendication 1, dans lequel :

- le condensateur ferroélectrique présente une boucle d'hystérésis polarisation contre champ électrique (P-E) qui peut être mesurée à partir d'à peine 1 Hz ; ou
- le condensateur ferroélectrique présente une transmittance totale de lumière incidente d'au moins 50, 60, 70, 80 ou 90 %.

**13.** Procédé de production d'un dispositif de mémoire à base de condensateur ferroélectrique (100) de l'une quelconque des revendications 1 à 12, le procédé comprenant :

EP 3 249 667 B1

(a) le dépôt d'une première couche de graphène dopée sur un substrat flexible (104) ou le dépôt d'une couche de graphène sur un substrat flexible (104) suivi du dopage de la couche de graphène pour produire une première couche de graphène dopée ;

(b) le dépôt d'une couche de précurseur ferroélectrique sur la première couche de graphène dopée et le recuit de la couche de précurseur ferroélectrique déposée pour obtenir une couche ferroélectrique (106) ayant des propriétés d'hystérésis ferroélectrique ; et

(c) le dépôt d'une électrode supérieure (108) comprenant une deuxième couche de graphène dopée sur la couche ferroélectrique ayant des propriétés d'hystérésis ferroélectrique pour obtenir le dispositif de mémoire à base de condensateur ferroélectrique.

14. Procédé de la revendication 13, dans lequel :

- le substrat (104) est flexible et le procédé comprend le dépôt de la couche de graphène sur le substrat flexible par un processus de rouleau à rouleau ; et/ou
- la couche de graphène est en graphène à dépôt chimique en phase vapeur (CYD) ou en graphène exfolié en phase liquide (LPE).

15. Carte de circuit imprimé, circuit intégré ou dispositif électronique comprenant le dispositif de mémoire à base de condensateur ferroélectrique (100) de l'une quelconque des revendications 1 à 12.

100

108          108              108

106

102

104

FIG. 1

FIG. 2

FIG. 3

FIG. 4

FIG. 5

600

( START )

DEFINING A TARGET ENERGY LEVEL FOR THE
FERROELECTRIC CAPACITOR — 602

CHARGING THE FERROELECTRIC CAPACITOR — 604

MEASURING A FIRST AMOUNT OF ENERGY THAT
IS STORED IN THE FERROELECTRIC CAPACITOR — 606

TERMINATING CHARGING OF THE
FERROELECTRIC CAPACITOR WHEN THE FIRST
AMOUNT OF ENERGY STORED IN THE CAPACITOR
REACHES THE TARGET LEVEL — 608

DISCHARGING THE CAPACITOR INTO THE CONSUMING
DEVICE WHEN ELECTRICAL POWER FROM THE PRIMARY
SOURCE BECOMES UNAVAILABLE — 610

*FIG. 6*

700

100

Cp

Rp

Vp

+

−

FIG. 7

800

108    108    108

802

102

104

FIG. 8

900

108    108    108

902

102

104

FIG. 9

FIG. 10

*FIG. 11*

*FIG. 12*

*FIG. 13*

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20110170330 A

**Non-patent literature cited in the description**

- **BAE et al.** *ACSNANO,* 2013, vol. 7, 313-3138
- **NI et al.** *ACSNANO,* 2012, vol. 6, 3935-3942
- **MAO et al.** *Organic Electronics,* 2010, vol. 11 (5), 925-932
- **SUKANG et al.** *Nature Nanotechnology,* 2010, vol. 5 (8), 574-478